# EUROPEAN PATENT APPLICATION

(11) **EP 4 628 910 A1**
(43) Date of publication of application: **08.10.2025**
(21) Application number: 25165831.6
(22) Date of filing: 25.03.2025
(51) Int. Cl.: G01R 31/36, G01R 31/389

(54) **CHARACTERISTIC MEASURING JIG OF BATTERY CELL FOR RECHARGEABLE BATTERY AND MEASURING APPARATUS INCLUDING THE SAME**

(30) Priority: 28.03.2024 KR 20240042665
(71) Applicant: SAMSUNG SDI CO., LTD., Yongin-si, Gyeonggi-do 17084 (KR)
(72) Inventor: SHIN, Eui-Chol, 17084 Gyeonggi-do (KR)
(74) Representative: Michalski Hüttermann & Partner Patentanwälte mbB

(57) **Abstract**

A characteristic measuring jig of a battery cell for a rechargeable battery according to an embodiment of the present disclosure includes a support on which a battery cell including a positive electrode terminal and a negative electrode terminal is provided, an impedance measuring part that is detachable to the positive electrode terminal and the negative electrode terminal of the battery cell, and an elevating part connected to the impedance measuring part to be fixed to the support, and configured to elevate the impedance measuring part. The impedance measuring part includes first and second positive electrode contact parts in contact with the positive electrode terminal, first and second negative electrode contact parts in contact with the negative electrode terminal and disposed opposite to the first and second positive electrode contact parts, a first terminal for current connected to the first positive electrode contact part and for applying current to the battery cell, a first terminal for voltage connected to the second positive electrode contact part and for measuring the voltage of the battery cell, a second terminal for current connected to the first negative electrode contact part and for applying current to the battery cell, and a second terminal for voltage connected to the second negative electrode contact part and for measuring voltage of the battery cell. The elevating part is connected to the first and second positive electrode contact parts or the first and second negative electrode contact parts, and is configured to elevate the first and second positive electrode contact parts or the first and second negative electrode contact parts with respect to the battery cell. The first terminal for current is disposed opposite to the first terminal for voltage, and the second terminal for current is disposed opposite to the second terminal for voltage.

## Description

### BACKGROUND

### 1. Field

The present disclosure relates to a characteristic measuring apparatus of a battery cell, and to an apparatus for measuring the impedance of a battery cell.

### 2. Description of the Related Art

Unlike primary batteries, rechargeable batteries are batteries that may be repeatedly charged and discharged. Small-capacity rechargeable batteries are used in small, portable electronic devices such as mobile phones, laptop computers, and camcorders. High-capacity and high-density rechargeable batteries are used as power sources for driving motors in hybrid and electric vehicles or for energy storage.

The rechargeable batteries may be provided to consumers after undergoing characteristic tests on the stability and performance characteristics of the battery cells. One of the characteristic tests includes an impedance test of the battery cells of the rechargeable battery.

When measuring the impedance of battery cells, it is important to ensure that the impedance to be measured is not distorted due to an increase in inductance due to the structure or arrangement of measurement equipment components (e.g., current lines, voltage lines).

The above information disclosed in this Background section is only for enhancement of understanding of the background of the described technology and therefore it may contain information that does not form the prior art that is already known in this country to a person of ordinary skill in the art.

### SUMMARY

The present disclosure provides a characteristic measuring apparatus of a battery cell capable of minimizing the influence of inductance when measuring the impedance of a battery cell.

Effects that may be obtained from the present disclosure will not be limited to only the above-described effects. In addition, other effects which are not described herein will become apparent to those skilled in the art from the following description.

A characteristic measuring jig configured to measure one or more characteristics of a battery cell for a rechargeable battery according to an embodiment of the present disclosure includes a support configured to support the battery cell including a positive electrode terminal and a negative electrode terminal, an impedance measuring part that is detachable from the positive electrode terminal and the negative electrode terminal of the battery cell, and an elevating part connected to the impedance measuring part to be fixed to the support and configured to elevate the impedance measuring part.

The impedance measuring part may include first and second positive electrode contact parts in contact with the positive electrode terminal, first and second negative electrode contact parts in contact with the negative electrode terminal and substantially opposite to the first and second positive electrode contact parts, a first terminal for current connected to the first positive electrode contact part and configured to apply current to the battery cell, a first terminal for voltage connected to the second positive electrode contact part and configured to measure the voltage of the battery cell, a second terminal for current connected to the first negative electrode contact part and configured to apply current to the battery cell, and a second terminal for voltage connected to the second negative electrode contact part and configured to measure voltage of the battery cell.

The elevating part may be connected to the first and second positive electrode contact parts or the first and second negative electrode contact parts, and is configured to elevate the first and second positive electrode contact parts or the first and second negative electrode contact parts with respect to the battery cell.

The first terminal for current may be substantially opposite to the first terminal for voltage, and the second terminal for current is substantially opposite to the second terminal for voltage.

The impedance measuring part may include a first body to which the first and second positive electrode contact parts, the first terminal for current, and the first terminal for voltage are coupled, and a second body to which the first and second negative electrode contact parts, the second terminal for current, and the second terminal for voltage are coupled.

The first terminal for current and the first terminal for voltage may be non-overlapping on a same line in the first body.

The second terminal for current and the second terminal for voltage may be non-overlapping on the same line in the second body.

The area of the first positive electrode contact part may be equal to or larger than the area of the second positive electrode contact part.

The area of the first negative electrode contact part may be equal to or greater than the area of the second negative electrode contact part.

The second body may be fixedly installed on the support, and the first body may be connected to the elevating part.

The support may include a bottom plate and a vertical plate extending from one side of the bottom plate, and the second body may be on the bottom plate.

The battery cell may be cylindrical.

A measuring apparatus configured to measure one or more characteristics of a battery cell for a rechargeable battery according to an embodiment of the present disclosure includes a housing in which the above-described measuring jig is accommodated, the housing having a chamber including a current wire configured to apply current to the first and second terminals for current, and a voltage wire configured to sense voltage of the battery cell from the first and second terminals for voltage.

According to the embodiments of the present disclosure, the inductance may be reduced when measuring the impedance of a battery cell as the terminals for current and the voltage of the measuring jig are non-overlapping.

Accordingly, it is possible to improve the distortion of the impedance of the battery cell to be measured by reducing the resistance that interferes with the flow of current.

### BRIEF DESCRIPTION OF THE DRAWINGS

The accompanying drawings illustrate preferred embodiments of the present disclosure and, together with the foregoing disclosure, serve to provide further understanding of the technical idea of the present disclosure. However, the present disclosure is not to be construed as being limited to the drawings.
FIG. 1 is a perspective view schematically illustrating a characteristic measuring apparatus configured to measure characteristic(s) of a battery cell for a rechargeable battery according to embodiments of the present disclosure.
FIG. 2 is a perspective view schematically illustrating a measuring jig according to embodiments of the present disclosure.
FIG. 3 is a partial enlarged view of a portion of the measuring jig in FIG. 2.
FIG. 4 is a perspective view illustrating a battery cell according to embodiments of the present disclosure.
FIGS. 5A to 5D depict an impedance measuring part according to embodiments of the present disclosure.
FIGS. 6A and 6B are graphs depicting the charge exchange resistance (Rct) and the inductance of a battery cell as measured by an embodiment of the measuring jig compared to a related art measuring device.

### DETAILED DESCRIPTION

Hereinafter, preferred embodiments of the present disclosure will be described in detail with reference to the accompanying drawings. Prior to making the description, the terms or words used in the specification and claims of the present disclosure are not interpreted using typical or dictionary limited meanings, and are constructed as meanings and concepts conforming to the technical idea of the present disclosure based on the principle that the inventors can appropriately define the concepts of the terms to explain the present disclosure in the best manner. Accordingly, it is to be understood that the detailed description, which will be disclosed along with the accompanying drawings, is intended to describe the embodiments of the present disclosure and is not intended to represent all technical ideas of the present disclosure. Therefore, it should be understood that various equivalents and modifications can exist which can replace the embodiments described in the time of the application.

It will be further understood that the terms "comprise or include" and/or "comprising or including," when used in this specification, specify the presence of stated features, numbers, steps, operations, elements, and/or components, but do not preclude the presence or addition of one or more other features, numbers, steps, operations, elements, components, and/or groups thereof.

In addition, for ease of understanding of the present disclosure, the accompanying drawings are not drawn to real scale, but the dimensions of some components may be exaggerated. In addition, the same reference numbers may be assigned to the same components in different embodiments.

Stating that two objects of comparison are 'the same' means that they are 'substantially the same'. Therefore, substantially identical may include a deviation that is considered low in the art, for example, a deviation of less than 5 %. Additionally, uniformity of a parameter in a certain region may mean uniformity from an average perspective.

Although terms of "first," "second," and the like are used to explain various constituent elements, the constituent elements are not limited to such terms. These terms are only used to distinguish one constituent element from another constituent element. Unless explicitly described to the contrary, the second constituent element may be referred to as the first constituent element.

Throughout the specification, unless otherwise stated, each component may be singular or plural.

It will also be understood that when a first element or layer is referred to as being present "on" or "beneath" a second element or layer, the first element may be disposed directly on or beneath the second element or may be disposed indirectly on or beneath the second element with a third element or layer being disposed between the first and second elements or layers.

It should be noted that if it is described in the specification that one component is "connected" or "coupled" on another component, a third component may be "connected," "coupled," and "joined" between the first and second components, or the first component may be directly connected, coupled, or joined to the second component.

As used herein, the term "and/or" includes any one and all combinations of one or more of the associated listed items. Additionally, the use of "may" when describing embodiments of the present disclosure relates to "one or more embodiments of the present disclosure."

Expressions such as "one or more" and "at least" preceding a list of elements modify the entire list of elements and do not modify individual elements in the list.

When referring to "A and/or B" throughout the specification, it means A, B, or A and B, unless specifically stated to the contrary. When referring to "C to D", it means that it is greater than or equal to C and less than or equal to D, unless otherwise specified.

When the phrases such as "at least one of A, B, and C," "at least one of A, B, or C," "at least one selected from the group of A, B, and C," and "at least one selected from A, B, and C" are used to specify a list of elements A, B, and C, and the phrases may refer to any suitable combination.

The term "use" may be considered synonymous with the term "utilize."

As used herein, the terms "substantially," "about," and similar terms are used as terms of approximation and are intended to account for inherent variations in the measured or calculated values that would be recognized by a person of ordinary skill in the art.

It will be understood that, although the terms first, second, third, etc., may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

Spatially relative terms, such as "beneath," "below," "lower," "above," "upper," and the like, may be used herein for ease of description to describe one element or feature's relationship to another element(s) or feature(s) as illustrated in the drawings. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "on" or "above" the other elements or features. Thus, the term "below" can encompass both an orientation of above and below.

The terminology used herein is for the purpose of describing particular embodiments only and is not intended to be limiting of the disclosure.

In embodiments of the present disclosure, one of the prismatic and pouch-type rechargeable batteries is selected and the selected battery is described as having a general structure, and the general structure of the prismatic and pouch-type rechargeable battery is described in the case of generally applied technology.

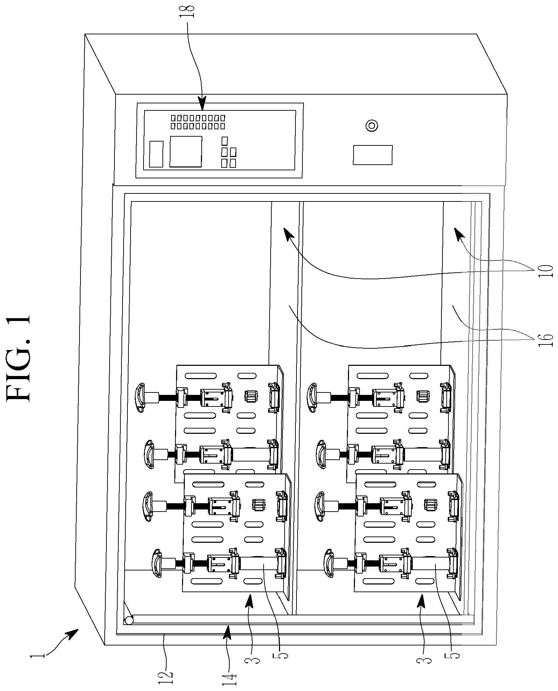

FIG. 1 is a perspective view schematically illustrating a characteristic measuring apparatus for measuring a characteristic of a battery cell for a rechargeable battery (hereinafter referred to as a measuring apparatus for convenience) according to embodiments.

A measuring apparatus 1 is configured to measure the characteristics of a rechargeable battery through a characteristic measuring jig 3 (hereinafter referred to as a measuring jig for convenience) disposed in a measuring chamber 10. In one embodiment, the measuring jig 3 is configured to measure the impedance of the battery cell.

The measuring chamber 10 may be include a plurality of measuring chambers 10 due to a frame 14 within the body 12 of the measuring apparatus 1 and a separator 16 connected to the frame 14.

Further, an operation panel 18 is installed on the body 12 of the measuring apparatus 1 for electrical operations such as adjusting the temperature or humidity in the measuring chamber 10 and applying a current to a battery cell 5 to measure the impedance of the battery cell 5 provided in the measuring jig 3.

In addition, the measuring chamber 10 may include a current line each electrically connected to the measuring jig 3 to apply current to the battery cell 5, and a voltage line for sensing the voltage from the battery cell 5.

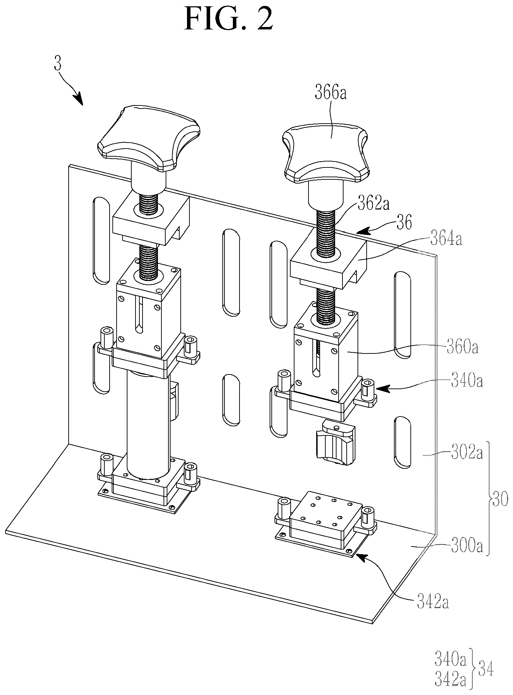

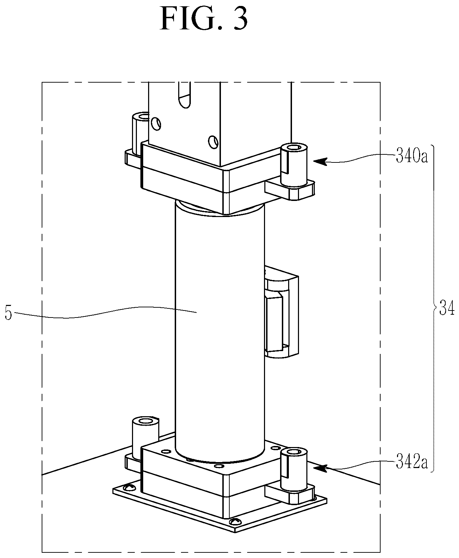

FIG. 2 is a perspective view schematically illustrating a measuring jig according to embodiments, and FIG. 3 is a partial enlarged view of FIG. 2. As shown in FIGS. 2 and 3, the measuring jig 3 of the embodiments includes a support 30 configured to support the battery cell 5.

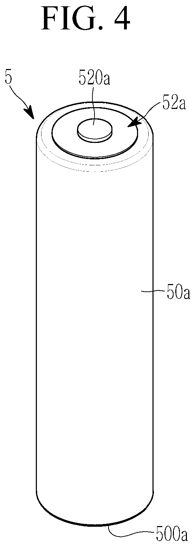

In one or more embodiments, the battery cell 5 may be a cylindrical battery cell, as can be further seen in FIG. 4. The battery cell 5 may include an electrode assembly including a positive electrode, a negative electrode, and a separator accommodated within a cylindrical case 50a, with an opening in the case 50a sealed by a cap assembly 52a that is electrically connected to the positive electrode. A protruding portion of the cap assembly 52a, such as a cap included in the cap assembly 52a, may function as a positive electrode terminal 520a of the battery cell 5, and one side portion of the case 50a (e.g., a bottom surface of the case) that is electrically connected to the negative electrode of the electrode assembly may function as a negative electrode terminal 500a of the battery cell 5.

Referring again to FIGS. 2 and 3, the support 30 on which the battery cell 5 is provided to measure the impedance includes a bottom plate 300a and a vertical plate 302a extending from one edge of the bottom plate 300a. On the vertical plate 302a, the first section of an impedance measuring part 34 (for example, a positive electrode contact part and a first terminal, to be described later) for measuring the impedance of the battery cell 5 may be provided, and on the bottom plate 300a, the second section of the impedance measuring part 34 (for example, a negative electrode contact part and a second terminal, to be described later) may be provided.

The number of impedance measuring parts 34 on the support 30 may vary depending on the number of battery cells 5 that are intended to be supported. In the present embodiment, the battery cell 5 is provided for each of the two impedance measuring parts 34 (only one battery cell is shown in FIG. 2 for convenience), but the structure of the measuring jig 3 is not limited thereto.

In addition, an elevating part 36 configured to elevate the first section of the impedance measuring part 34 while being detachably attached to a terminal of the battery cell 5, such as the positive electrode terminal 520a, is fixedly coupled on the vertical plate 302a.

The impedance measuring part 34 includes a positive electrode contact part 340a configured to contact the positive electrode terminal 520a and a negative electrode contact part 342a configured contact the negative electrode terminal 500a of the battery cell 5.

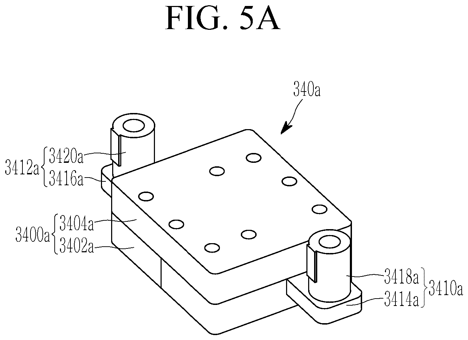

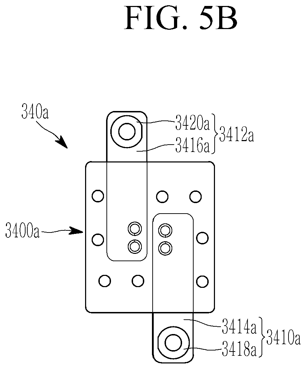

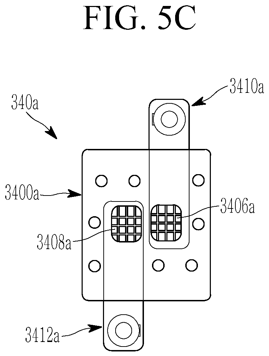

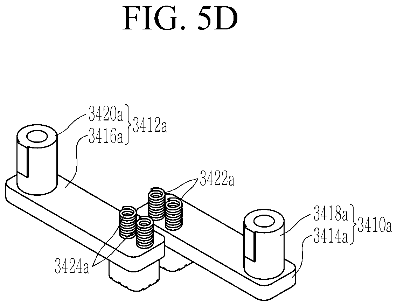

FIGS. 5A to 5D depict the positive electrode contact part 340a. Referring to FIGS. 5A to 5D, the positive electrode contact part 340a includes a first body 3400a having a substantially rectangular parallelepiped shape. The first body 3400a includes a lower body 3402a and an upper body 3404a configured to be detachably coupled to each other. On the lower body 3402a, first and second positive electrode contact parts 3406a and 3408a, respectively, configured to contact the positive electrode terminal 520a, are spaced apart from each other at an interval. The first and second positive electrode contact parts 3406a and 3408a are configured in the lower body 3402a so that their tip parts are exposed outside of the lower body 3402a and are configured to move upward and downward with respect to the lower body 3402a.

A first terminal for current 3410a and a first terminal for voltage 3412a are connected to the first and second positive electrode contact parts 3406a and 3408a, respectively. The first terminal for current 3410a is connected to the first positive electrode contact part 3406a so that current (alternating current) is applied to the battery cell 5. Additionally, the first terminal for voltage 3412a is connected to the second positive electrode contact part 3408a to measure the voltage from the battery cell 5.

In one or more embodiments, the first terminal for current 3410a and the first terminal for voltage 3412a include oppositely arranged rod-shaped lead parts 3414a and 3416a, respectively, and cylinder-shaped connectors 3418a and 3420a, respectively, extending vertically from one end of the lead parts 3414a and 3416a, respectively.

In one or more embodiments, both lead parts 3414a and 3416a are arranged non-collinearly and in parallel (or substantially in parallel). That is, with the first and second positive electrode contact parts 3406a and 3408a arranged at approximately the center of the first body 3400a, both lead parts 3414a and 3416a are arranged on the first body 3400a such that their respective connectors 3418a and 3420a are oppositely arranged. Accordingly, the angle between the two lead parts 3414a and 3416a, that is, the angle between the first terminal for current 3410a and the first terminal for voltage 3412a is approximately 180°. The arrangement of the first terminal for current 3410a and the first terminal for voltage 3412a is effective in preventing (or at least mitigating) distortion of the impedance to be measured by minimizing the overlapping region between the two terminals and thereby reducing the increase in inductance due to the magnetic field.

In one or more embodiments, the lead parts 3414a and 3416a are non-collinear line as described above, but in another embodiment, the lead parts 3414a and 3416a may be arranged on the same line (i.e., co-linear or substantially co-linear).

Additionally, in one or more embodiments, the lead parts 3414a and 3416a are arranged with an angle of approximately 180° as described above, but may also be arranged with an angle selected between approximately 90° and approximately 180°.

A current wire for applying current to the first terminal for current 3410a and a voltage wire for sensing voltage of the battery cell 5 from the first terminal for voltage 3412a are connected to the connectors 3418a and 3420a, respectively.

A part of the lead parts 3414a and 3416a, including the connectors 3418a and 3420a, is exposed outside of the first body 3400a, and the remaining part of the lead parts 3414a and 3416a, including the first and second positive electrode contact parts 3406a and 3408a connected to different ends of the lead parts 3414a and 3416a, is within the first body 3400a.

Springs 3422a and 3424a are on the other ends of the lead parts 3414a and 3416a, respectively, to which the first and second positive electrode contact parts 3406a and 3408a are connected opposite the first and second positive electrode contact parts 3406a and 3408a. The springs 3422a and 3424a are configured to enable the first and second positive electrode contact parts 3406a and 3408a, respectively, to elastically contact the positive electrode terminal 520a by the force exerted by the elevating part, which will be described later.

In one or more embodiments, the area of the first positive electrode contact part 3406a may be equal to or larger than the area of the second positive electrode contact part 3408a, which is configured to reduce heat generation in response to actual current flowing by reducing the contact resistance of the current terminal.

In one or more embodiments, the negative electrode contact part 342a may be configured in the same way as the positive electrode contact part 340a. That is, the negative electrode contact part 342a may also include a second body (lower body/upper body), first and second negative electrode contact parts, a second terminal for current (the lead part and the connector), a second terminal for voltage, and a spring.

The first and second negative electrode contact parts contact the negative electrode terminal 500a of the battery cell 5. The detailed description of this will be replaced with the description of the above-described positive electrode contact part 340a.

The impedance measuring part 34 is connected to the elevating part 36, which is fixedly installed to the vertical plate 302a of the support 30, so that the impedance measuring part 34 is configured to move up and down.

As can be seen through FIG. 2, in one embodiment, the elevating part 36 is configured to elevate the positive electrode contact part 340a utilizing a screw.

In one or more embodiments, the elevating part 36 includes a pressing part 360a connected (e.g., screwed) to the positive electrode contact part 340a, an elevating shaft 362a connected to the pressing part 360a and including threads, a mount holder 364a fixed to the vertical plate 302a and coupled to the elevating shaft 362a such that the elevating shaft 362a may be elevated and guided in a screwed manner, and a handle part 366a coupled to one end of the elevating shaft 362a. The negative electrode contact part 342a is fixed to the bottom plate 300a of the support 30.

Accordingly, when the battery cell 5 is placed on the negative electrode contact part 342a so that the negative electrode terminal 500a of the battery cell 5 contacts the first and second negative electrode contact parts, in response to the user rotating the handle part 366a clockwise manner, the elevating shaft 362a descends and the pressing part 360a and the positive electrode contact part 340a also descend in conjunction therewith.

As a result, the first and second positive electrode contact parts 3406a and 3408a contact the positive electrode terminal 520a of the battery cell 5. In this state, the impedance of the battery cell 5 may be measured by allowing current to be applied to the first terminal for current 3410a and the second terminal for current, and sensing the voltage through the first terminal for voltage 3412a and the second terminal for voltage. In one or more embodiments, the first terminal for current 3410a and the first terminal for voltage 3412a are arranged substantially in a straight line so as not to overlap each other, and the second terminal for current and the second terminal for voltage are also arranged so as not to overlap each other. Therefore, it is possible to reduce the increase in inductance due to the magnetic field, thereby measuring the impedance of the battery cell 5 without distortion.

Once the measurement of the impedance is completed, the user may rotate the handle part 366a counterclockwise so that the first and second positive electrode contact parts 3406a and 3408a are separated from the positive electrode terminal 520a of the battery cell 5, and the first and second negative electrode contact parts are separated from the negative electrode terminal 500a of the battery cell 5. Afterwards, the battery cell 5 for which the impedance measurement has been completed may be replaced with a new battery cell that will be measured for impedance.

In one or more embodiments, it is illustrated that the positive electrode contact part 340a is elevated by the elevating part 36, and the negative electrode contact part 342a is fixed to the support 30, but the opposite case is also possible. That is, the negative electrode contact part 342a may be elevated by the elevating part 36, and the positive electrode contact part 340a may be fixed to the support 30.

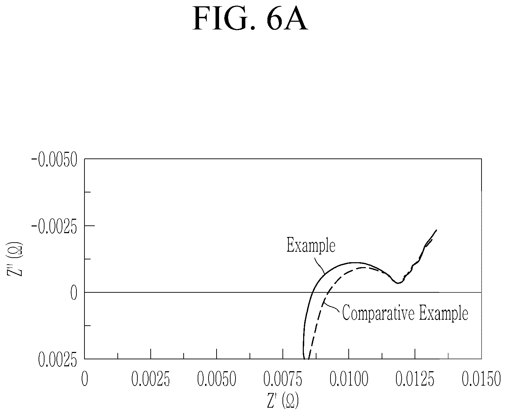

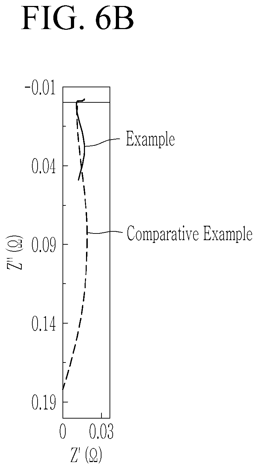

FIGS. 6A and 6B are graphs illustrating the results of measuring charge exchange resistance (Rct) and inductance for the battery cell 5 on a measuring jig 3 according to an example and a measuring jig according to a comparative example, respectively. In the measuring jig according to the comparative example, unlike the embodiment, the first and second terminals for current and the first and second terminals for voltage for the positive electrode terminal and the negative electrode terminal of the battery cell overlap each other and are integrated into one body. The battery cells measured by each measuring jig are cylindrical battery cells as shown in FIG. 4.

As can be seen from FIGS. 6A and 6B, when measuring the impedance of a battery cell using the measuring jig 3 of the embodiment, the improved terminals for current and voltage reduce inductance, thereby allowing impedance to be measured without distortion (or with improved distortion of) the charge exchange resistance (Rct).

While the embodiments of the present disclosure have been described in detail, it is to be understood that the disclosure is not limited to the disclosed embodiments, but on the contrary, is intended to cover various modifications and equivalent arrangements included within the scope of the appended claims.

### Reference signs

3: Measuring jig
5: Battery cell
30: Support
34: Impedance measuring part
36: Elevating part
340a: Positive electrode contact part
342a: Negative electrode contact part
3406a: First positive electrode contact part
3408a: Second positive electrode contact part
3410a: First terminal for current
3412a: First terminal for voltage
3414a, 3416a: Lead part
3418a,3420a: Connector

## Claims

1. A characteristic measuring jig (3) configured to measure a characteristic of a battery cell (5) for a rechargeable battery, the characteristic measuring jig (3) comprising:
a support (30) configured to support (30) the battery cell (5), the battery cell (5) comprising a positive electrode terminal (520a) and a negative electrode terminal (500a);
an Impedance measuring part (34) comprising:
first and second positive electrode contact parts (3406a, 3408a) configured to contact the positive electrode terminal (520a),
first and second negative electrode contact parts configured to contact the negative electrode terminal (500a), the first and second negative electrode contact parts being opposite to the first and second positive electrode contact parts (3406a, 3408a),
a first terminal for current (3410a) connected to the first positive electrode contact part (340a, 3406a) and configured to apply current to the battery cell (5),
a first terminal for voltage (3412a) connected to the second positive electrode contact part (342a, 3408a) and configured to measure the voltage of the battery cell (5),
a second terminal for current connected to the first negative electrode contact part and configured to apply current to the battery cell (5), and
a second terminal for voltage connected to the second negative electrode contact part and configured to measure voltage of the battery cell (5), and that is detachable to the positive electrode terminal (520a) and the negative electrode terminal (500a) of the battery cell (5); and
an elevating part (36) fixed to the support (30), connected to the first and second positive electrode contact parts (3406a, 3408a) or the first and second negative electrode contact parts, and configured to elevate the first and second positive electrode contact parts (3406a, 3408a) or the first and second negative electrode contact parts with respect to the battery cell (5),
wherein the first terminal for current (3410a) is substantially opposite to the first terminal for voltage (3412a), and
wherein the second terminal for current is substantially opposite to the second terminal for voltage.

2. The characteristic measuring jig (3) as claimed in claim 1, wherein the Impedance measuring part (34) comprises:
a first body (3400a) to which the first and second positive electrode contact parts (3406a, 3408a), the first terminal for current (3410a), and the first terminal for voltage (3412a) are coupled; and
a second body to which the first and second negative electrode contact parts, the second terminal for current, and the second terminal for voltage are coupled.

3. The characteristic measuring jig (3) as claimed in claim 1 or 2, wherein the first terminal for current (3410a) and the first terminal for voltage (3412a) are non-overlapping on a same line in the first body (3400a).

4. The characteristic measuring jig (3) as claimed in any one of claims 1 to 3, wherein the second terminal for current and the second terminal for voltage are non-overlapping on a same line in the second body.

5. The characteristic measuring jig (3) as claimed in any one of claims 1 to 4, wherein an area of the first positive electrode contact part (340a, 3406a) is equal to or greater than an area of the second positive electrode contact part (342a, 3408a).

6. The characteristic measuring jig (3) as claimed in any one of claims 1 to 5, wherein an area of the first negative electrode contact part is equal to or greater than an area of the second negative electrode contact part.

7. The characteristic measuring jig (3) as claimed in any one of claims 1 to 6, wherein the second body is fixedly coupled on the support (30), and wherein the first body (3400a) is coupled to the elevating part (36).

8. The characteristic measuring jig (3) as claimed in any one of claims 1 to 7, wherein the support (30) comprises a bottom plate (300a) and a vertical plate (302a) extending from one side of the bottom plate (300a), and wherein the second body is on the bottom plate (300a).

9. The characteristic measuring jig (3) as claimed in any one of claims 1 to 8, wherein the battery cell (5) is cylindrical.

10. A measuring apparatus (1) configured to measure a characteristic of a battery cell (5) for a rechargeable battery, the measuring apparatus (1) comprising:
a housing accommodating the characteristic measuring jig (3) as claimed in any one of claims 1 to 9, the housing comprising a chamber (10), a current wire configured to apply current to the first and second terminals for current, and a voltage wire configured to sense voltage of the battery cell (5) from the first and second terminals for voltage.
